(19) Europäisches Patentamt / European Patent Office / Office européen des brevets

(11) **EP 4 345 468 B1**

(12) **EUROPEAN PATENT SPECIFICATION**

(45) Date of publication and mention
of the grant of the patent:
**13.05.2026  Bulletin 2026/20**

(21) Application number: **22879587.8**

(22) Date of filing: **09.12.2022**

(51) International Patent Classification (IPC):
**G01R 31/12** *(2020.01)*    **G01H 1/00** *(2006.01)*
**G01H 3/06** *(2006.01)*    **G01H 3/12** *(2006.01)*

(52) Cooperative Patent Classification (CPC):
**G01R 31/1209; G01H 1/00; G01H 3/06; G01H 3/12**

(86) International application number:
**PCT/CN2022/138023**

(87) International publication number:
**WO 2024/036836 (22.02.2024 Gazette 2024/08)**

(54) **ADAPTIVE CONDITIONING CIRCUIT SUPPORTING ULTRASONIC-VIBRATION FUSION, AND FLEXIBLE MODULE**

ADAPTIVE KONDITIONIERUNGSSCHALTUNG ZUR UNTERSTÜTZUNG VON ULTRASCHALLVIBRATIONSFUSION UND FLEXIBLES MODUL

CIRCUIT DE CONDITIONNEMENT ADAPTATIF SUPPORTANT LA FUSION DE VIBRATIONS/ ULTRASONS ET MODULE FLEXIBLE

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**

(30) Priority: **15.08.2022  CN 202210976852**

(43) Date of publication of application:
**03.04.2024  Bulletin 2024/14**

(73) Proprietor: **State Grid Zhejiang Ningbo Power Supply Company**
**Ningbo, Zhejiang 315016 (CN)**

(72) Inventors:
- **JIANG, Jiongting**
  **Ningbo**
  **Zhejiang 315016 (CN)**
- **HAN, Xutao**
  **Ningbo**
  **Zhejiang 315016 (CN)**
- **JIANG, Keruo**
  **Ningbo**
  **Zhejiang 315016 (CN)**
- **SONG, Yanfeng**
  **Ningbo**
  **Zhejiang 315016 (CN)**
- **MA, Lijun**
  **Ningbo**
  **Zhejiang 315016 (CN)**
- **LI, Junhao**
  **Ningbo**
  **Zhejiang 315016 (CN)**
- **QIAN, Kai**
  **Ningbo**
  **Zhejiang 315016 (CN)**
- **XIA, Qiaoqun**
  **Ningbo**
  **Zhejiang 315016 (CN)**
- **YANG, Yueping**
  **Ningbo**
  **Zhejiang 315016 (CN)**
- **SHAO, Zhipeng**
  **Ningbo**
  **Zhejiang 315016 (CN)**
- **ZHANG, Zhaoyu**
  **Ningbo**
  **Zhejiang 315016 (CN)**

(74) Representative: **Meyer, Thorsten**
**Meyer Patentanwaltskanzlei**
**Pfarrer-Schultes-Weg 14**
**89077 Ulm (DE)**

(56) References cited:
WO-A1-2022/014741    CN-A- 104 360 252
CN-A- 109 444 691    CN-A- 109 507 303
CN-A- 110 687 388    CN-A- 110 687 388
CN-A- 113 945 867    CN-A- 115 078 937

## Description

## TECHNICAL FIELD

The present disclosure relates to the technical field of detection, and in particular, to an adaptive conditioning circuit supporting ultrasonic-vibration fusion, and a corresponding flexible module.

## BACKGROUND

For an electrical device suffering from electrical stress, a partial discharge occurs when there is an insulation defect inside the electrical device. During the partial discharge, an ultrasonic signal is radiated outward. An insulation status of the electrical device can be detected and analyzed by measuring the ultrasonic signal. Similarly, for a mechanical device suffering from mechanical stress, an abnormal vibration occurs when there is a mechanical defect inside the mechanical device. A mechanical status of the mechanical device can be detected and analyzed by measuring and analyzing a vibration signal of the device. Partial discharge ultrasonic and mechanical vibration detection is widely used in many fields such as electric power, transportation, and aerospace.

With the rapid development of science and technology, a core device in a power grid is often both a power device and a mechanical device, and bears joint action of the electrical stress and the mechanical stress in an actual operation process, such as a power transformer, a gas insulated switchgear (GIS), and a wind generator. During operation of these devices, the mechanical status and the insulation status are coupled with each other, and have an extremely prominent reciprocal effect. Therefore, when an operation status of such a device is detected, a partial discharge ultrasonic signal reflecting the electrical status of the device and a vibration signal reflecting the mechanical status of the device need to be detected simultaneously. An ultrasonic-vibration fusion detection sensor can detect ultrasonic and vibration signals of the device simultaneously at a same place to realize fusion measurement of the signals from a sensing level, so as to obtain more comprehensive operation status information of the device. The ultrasonic-vibration fusion detection sensor has a broad application prospect in effective and comprehensive detection of the operation status of the device.

A physical signal sensed by the sensor needs to undergo amplification, filtering, and other processing to improve a signal-to-noise ratio of a detection signal. However, an existing ultrasonic signal conditioning circuit and vibration signal conditioning circuit can only process a single signal and cannot meet a conditioning requirement of an ultrasonic-vibration fusion signal. This is mainly reflected in that the power device in a new power system has a complex and changeable operation condition and operation environment, which leads to great uncertainty in amplitudes and frequencies of the ultrasonic signal and the vibration signal that are excited when the device operates, and an interference signal at an operation site is also increasingly complex and changeable. Signal conditioning needs to adapt to an operation condition status and the operation condition of the device. In addition, a common single parameter conditioning module is integrated into an ultrasonic sensor or a vibration sensor. However, due to introduction of a variety of sensing units, internal space of the vibration-ultrasonic fusion sensor is compact. Therefore, modules and units of a traditional conditioning circuit are difficult to be placed inside the vibration-ultrasonic fusion sensor. Therefore, a new and applicable signal conditioning circuit and a corresponding circuit module easy to be placed in the fusion sensor are needed for conditioning of the ultrasonic-vibration fusion signal.

Reference document CN110687388A discloses an internal defect detection circuit of a converter transformer which is composed of a broadband acoustic wave sensor, a signal separator, a low-frequency signal conditioning unit, a high-frequency signal conditioning unit, a digital-to-analog conversion unit, and a wireless data transmission unit, and the circuit couples acoustic wave signals through a sensor, separates the signals into vibration wave signals and ultrasonic signals. By performing digital-to-analog conversion on the vibration waves and ultrasonic signals, and transmitting digital signals through wireless technology, internal defects of commutation can be obtained. Reference document CN109444691A discloses a ultrasonic acquisition device which is used for acquiring ultrasonic partial discharge signals, including a composite sensor, an amplification circuit, a filter circuit, a detection circuit, and a voltage feedback amplification and voltage stabilization circuit, which are sequentially connected in series. An output of the voltage feedback amplification and voltage stabilization circuit is connected to the input of a data transmission unit.

## SUMMARY

**In** order to overcome the shortcomings and deficiencies of the prior art, and to realize effective conditioning of an ultrasonic-vibration fusion signal and reliable implantation of a conditioning circuit module, the present disclosure provides an adaptive conditioning circuit supporting ultrasonic-vibration fusion and a corresponding flexible module.

At first, an adaptive conditioning circuit supporting ultrasonic-vibration fusion provided in the present disclosure includes a front-end conditioning unit, a vibration conditioning unit, an ultrasonic conditioning unit, and a microcontroller unit, MCU, where the vibration conditioning unit and the ultrasonic conditioning unit both include a voltage following unit, a filtering unit, and a program-controlled amplification unit, an input terminal of the MCU is connected to an output terminal of the program-controlled amplification unit, and an output terminal of the MCU is separately connected to an input terminal of the filtering unit and an input terminal of the program-controlled amplification unit;

the front-end conditioning unit is configured to obtain an ultrasonic-vibration fusion signal collected by a sensor, and process the ultrasonic-vibration fusion signal to obtain two analog voltage signals;

the vibration conditioning unit is configured to perform adaptive filtering, denoising, and amplification on a vibration signal in the analog voltage signal;

the ultrasonic conditioning unit is configured to perform adaptive filtering, denoising, and amplification on an ultrasonic signal in the analog voltage signal; and

the MCU is configured to control the filtering and the denoising of the vibration conditioning unit and the ultrasonic conditioning unit, and adjust an amplification factor of the adaptive amplification based on feedback signals output by the vibration conditioning unit and the ultrasonic conditioning unit;

the MCU comprises an MCU controller, an analog-digital converter, ADC, and a digital-analog converter, DAC;

an output terminal of the vibration conditioning unit is connected to a signal input terminal of the ADC, and an analog signal on the output terminal of the vibration conditioning unit is output from a vibration feedback terminal of the ADC after undergoing analog-to-digital conversion; the vibration feedback terminal of the ADC is connected to an input terminal of the MCU controller, and an amplification factor used by the vibration conditioning unit for the vibration signal is controlled through a vibration amplification port of the MCU controller after internal processing by the MCU controller; a vibration filtering control port of the MCU controller is connected to an input terminal of the DAC, and a digital signal on the vibration filtering control port of the MCU controller is output from a vibration filtering port of the DAC after undergoing digital-to-analog conversion; and the vibration filtering port of the DAC is connected to an input terminal of the vibration conditioning unit to control the vibration conditioning unit to filter and denoise the vibration signal; and

an output terminal of the ultrasonic conditioning unit is connected to the signal input terminal of the ADC, and an analog signal on the output terminal of the ultrasonic conditioning unit is output from an ultrasonic feedback terminal of the ADC after undergoing the analog-to-digital conversion; the ultrasonic feedback terminal of the ADC is connected to the input terminal of the MCU controller, and an amplification factor used by the ultrasonic conditioning unit for the ultrasonic signal is controlled through an ultrasonic amplification port of the MCU controller after the internal processing by the MCU controller; an ultrasonic filtering control port of the MCU controller is connected to the input terminal of the DAC, and a digital signal on the ultrasonic filtering control port of the MCU controller is output from an ultrasonic filtering port of the DAC after undergoing the digital-to-analog conversion; and the ultrasonic filtering port of the DAC is connected to an input terminal of the ultrasonic conditioning unit to control the ultrasonic conditioning unit to filter and denoise the ultrasonic signal.

Optionally, the vibration conditioning unit includes a first voltage following unit, a vibration signal filtering unit, and a vibration program-controlled amplification unit, and the vibration signal filtering unit includes a fixed vibration signal filtering unit and a differential vibration signal denoising unit;

an input terminal of the first voltage following unit is connected to a first analog voltage signal, and an output terminal of the first voltage following unit is connected to an input terminal of the fixed vibration signal filtering unit;

an output terminal of the fixed vibration signal filtering unit is connected to an input terminal of the differential vibration signal denoising unit, the input terminal of the differential vibration signal denoising unit is also connected to a vibration filtering port of the MCU, and an output terminal of the differential vibration signal denoising unit is connected to an input terminal of the vibration program-controlled amplification unit; and

the input terminal of the vibration program-controlled amplification unit is also connected to a vibration amplification port of the MCU, and an output terminal of the vibration program-controlled amplification unit is connected to the input terminal of the MCU.

Optionally, the ultrasonic conditioning unit includes a second voltage following unit, an ultrasonic signal filtering unit, and an ultrasonic program-controlled amplification unit, and the ultrasonic signal filtering unit includes a fixed ultrasonic signal filtering unit and a differential ultrasonic signal denoising unit;

an input terminal of the second voltage following unit is connected to a second analog voltage signal, and an output terminal of the second voltage following unit is connected to an input terminal of the fixed ultrasonic signal filtering unit;

an output terminal of the fixed ultrasonic signal filtering unit is connected to an input terminal of the differential ultrasonic signal denoising unit, the input terminal of the differential ultrasonic signal denoising unit is also connected to an ultrasonic filtering port of the MCU, and an output terminal of the differential ultrasonic signal denoising unit is connected to an input terminal of the ultrasonic program-controlled amplification unit; and

the input terminal of the ultrasonic program-controlled amplification unit is also connected to an ultrasonic amplification port of the MCU, and an output terminal of the ultrasonic program-controlled amplification unit is connected to the input terminal of the MCU.

Optionally, the front-end conditioning unit includes a signal input interface and a third voltage following unit, an input terminal of the signal input interface receives the ultrasonic-vibration fusion signal collected by the sensor, an output terminal of the signal input interface is connected to an input terminal of the third voltage following unit, and an output terminal of the third voltage following unit outputs the two analog voltage signals.

Optionally, the adjusting an amplification factor of the adaptive amplification based on feedback signals of the ultrasonic-vibration fusion signal includes:

step 1: initializing the MCU, and setting the amplification factor of the program-controlled amplification unit to a maximum multiple, where the maximum multiple can be used to amplify a small signal to a full scale by default;

step 2: connecting a vibration output signal to an ADC module for analog-to-digital conversion, inputting an obtained vibration feedback digital signal to the MCU for digital processing;

step 3: obtaining an extreme value of a signal output by the program-controlled amplification unit;

step 4: determining whether an absolute value of the extreme value of the signal is between 1/3 of the full scale and 2/3 of the full scale; and ending adaptive adjustment if the absolute value of the extreme value of the signal is between 1/3 of the full scale and 2/3 of the full scale, or performing step 5 if the absolute value of the extreme value of the signal is not between 1/3 of the full scale and 2/3 of the full scale; and

step 5: adjusting the amplification factor of the program-controlled amplification unit by the MCU based on a preset step size, and repeating the steps 2 to 4 based on an adjusted amplification factor.

Optionally, the maximum multiple is a multiple used by the program-controlled amplification unit to amplify a unit signal to the full scale.

Optionally, the adjusting the amplification factor of the program-controlled amplification unit by the MCU based on a preset step size includes:

increasing the amplification factor by the preset step size when the absolute value of the extreme value of the signal is smaller than 1/3 of the full scale; or decreasing the amplification factor by the preset step size when the absolute value of the extreme value of the signal is greater than 2/3 of the full scale.

The present disclosure further provides a flexible module, where the flexible module is provided with the above-mentioned adaptive conditioning circuit supporting ultrasonic-vibration fusion.

Optionally, the flexible module is a flexible printed circuit board covered with an electromagnetic shielding film, and the flexible printed circuit board is installed on a housing of a sensor.

The technical solutions provided by the present disclosure have following beneficial effects:

The technical solutions provided in the present disclosure design an adaptive conditioning circuit supporting ultrasonic-vibration fusion and a flexible module to overcome a deficiency that existing ultrasonic and vibration signal conditioning circuits can only process single signals, which can realize adaptive amplification, filtering, denoising, and signal separation for an ultrasonic-vibration fusion signal based on respective signal characteristics in the ultrasonic-vibration fusion signal, and facilitate subsequent signal processing and feature analysis.

The flexible module can realize reliable implantation of a sensor in compact space, greatly improving portability and reliability of the sensor. The above features further make the flexible module provided in the present disclosure have advantages of adaptive amplification, adaptive filtering, a compact structure, high portability, high implantation reliability, anti-interference ability performance, and the like.

## BRIEF DESCRIPTION OF THE DRAWINGS

To describe the technical solutions in the present disclosure more clearly, the following briefly introduces the accompanying drawings required for describing the embodiments. Apparently, the accompanying drawings in the following description show merely some embodiments of the present disclosure, and a person of ordinary skill in the art may still derive other drawings from these accompanying drawings without creative efforts.

FIG. 1 is a schematic diagram of a modular architecture of an adaptive conditioning circuit supporting ultrasonic-vibration fusion according to Embodiment 1 of the present disclosure;

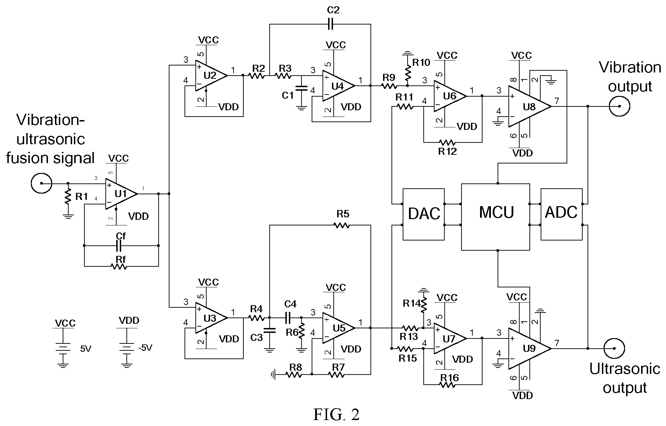

FIG. 2 is a principle diagram of an adaptive conditioning circuit supporting ultrasonic-vibration fusion according to Embodiment 1 of the present disclosure;

FIG. 3 is a schematic flowchart of controlling adaptive amplification by an MCU according to Embodiment 1 of the present disclosure;

FIG. 4 is an effect simulation diagram of an adaptive conditioning circuit supporting ultrasonic-vibration fusion according to Embodiment 1 of the present disclosure; and

FIG. 5 is a schematic diagram of installing a flexible module according to Embodiment 2 of the present disclosure.

## DETAILED DESCRIPTION

In order to make the objectives, technical solutions and advantages of the embodiments of the present disclosure clearer, the technical solutions in the embodiments of the present disclosure will be clearly and completely described below in conjunction with the accompanying drawings in the embodiments of the present disclosure. Obviously, the described embodiments are some rather than all of the embodiments of the present disclosure.

The terms "first", "second", "third", "fourth" and so on (if any) in the specification, claims and the accompanying drawings of the present disclosure are intended to distinguish between similar objects but do not necessarily indicate a specific order or sequence. It should be understood that the data used in such a way may be exchanged under proper conditions to make it possible to implement the described embodiments of the present disclosure in other sequences apart from those illustrated or described herein.

It should be understood that the serial number of each process in the above embodiments of the present disclosure does not indicate an order of performing the process. The order of performing each process is determined by its function and internal logic, and should not limit the implementation of the embodiments of the present disclosure.

It should be understood that the terms "include", "comprise" and their variants in the present disclosure mean to cover a non-exclusive inclusion. For example, a process, method, system, product or device that includes a list of steps or units is not necessarily limited to those steps or units which are clearly listed, but may include other steps or units which are not expressly listed or inherent to such a process, method, system, product, or device.

It should be understood that the term "a plurality of" in the present disclosure means two or more. The term "and/or" merely describes associations between associated objects, and it indicates three types of relationships. For example, A and/or B may indicate that A exists alone, A and B coexist, and B exists alone. The character "/" generally indicates that the associated objects are in an "or" relationship. "Including A, B and C" means that A, B and C are all included, "including A, B or C" means that one of A, B and C is included, and "including A, B and/or C" means that any one, two or three of A, B and C are included.

It should be understood that in the present disclosure, "B corresponding to A" means that B is associated with A, and B can be determined based on A. That determining B based on A means that B not only can be determined only based on A, and but also can be determined based on A and/or other information. A match between A and B is that a similarity between A and B is greater than or equal to a preset threshold.

Depending on the context, "if" used herein can be interpreted as "when", "in response to determining", or "in response to detection".

The technical solutions of the present disclosure will be described in detail below with reference to specific embodiments. The following specific embodiments may be combined with each other, and the same or similar concepts or processes may not be repeatedly described in some embodiments.

Embodiment 1

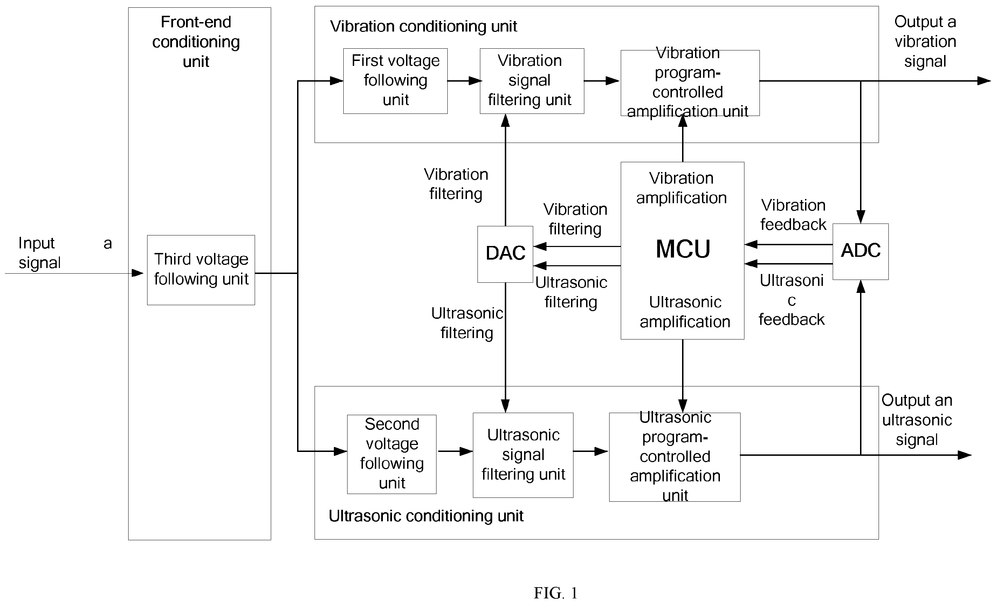

As shown in FIG. 1, according to the invention, this embodiment provides an adaptive conditioning circuit supporting ultrasonic-vibration fusion, including a front-end conditioning unit, a vibration conditioning unit, an ultrasonic conditioning unit, and an MCU. The vibration conditioning unit and the ultrasonic conditioning unit both include a voltage following unit, a filtering unit, and a program-controlled amplification unit, an input terminal of the MCU is connected to an output terminal of the program-controlled amplification unit, and an output terminal of the MCU is separately connected to an input terminal of the filtering unit and an input terminal of the program-controlled amplification unit.

The front-end conditioning unit is configured to obtain an ultrasonic-vibration fusion signal collected by a sensor, and process the ultrasonic-vibration fusion signal to obtain two analog voltage signals.

The vibration conditioning unit is configured to perform adaptive filtering, denoising, and amplification on a vibration signal in the analog voltage signal.

The ultrasonic conditioning unit is configured to perform adaptive filtering, denoising, and amplification on an ultrasonic signal in the analog voltage signal.

The MCU is configured to control the filtering and the denoising of the vibration conditioning unit and the ultrasonic conditioning unit, and adjust an amplification factor of the adaptive amplification based on feedback signals output by the vibration conditioning unit and the ultrasonic conditioning unit.

According to the invention, a feedback loop is separately formed between the vibration conditioning unit and the MCU, and between the ultrasonic conditioning unit and the MCU, so as to can realize adaptive amplification, filtering, denoising, and signal separation for the ultrasonic-vibration fusion signal based on respective signal characteristics in the ultrasonic-vibration fusion signal, facilitate subsequent signal processing and feature analysis, and overcome a deficiency that an existing circuit can only condition a single signal.

In this embodiment, the vibration conditioning unit includes a first voltage following unit, a vibration signal filtering unit, and a vibration program-controlled amplification unit, and the vibration signal filtering unit includes a fixed vibration signal filtering unit and a differential vibration signal denoising unit.
An input terminal of the first voltage following unit is connected to a first analog voltage signal, and an output terminal of the first voltage following unit is connected to an input terminal of the fixed vibration signal filtering unit. An output terminal of the fixed vibration signal filtering unit is connected to an input terminal of the differential vibration signal denoising unit, the input terminal of the differential vibration signal denoising unit is also connected to a vibration filtering port of the MCU, and an output terminal of the differential vibration signal denoising unit is connected to an input terminal of the vibration program-controlled amplification unit.

The input terminal of the vibration program-controlled amplification unit is also connected to a vibration amplification port of the MCU, and an output terminal of the vibration program-controlled amplification unit is connected to the input terminal of the MCU.

Further, the fixed vibration signal filtering unit is set as a second-order active low-pass filter with a cut-off frequency of 4000 Hz based on a frequency band from 1 Hz to 4000 Hz of the vibration signal. The fixed vibration signal filtering unit can obtain the vibration signal from the vibration-ultrasonic fusion signal and adaptively denoise and amplify the vibration signal.

Similar to vibration conditioning, in this embodiment, the ultrasonic conditioning unit includes a second voltage following unit, an ultrasonic signal filtering unit, and an ultrasonic program-controlled amplification unit, and the ultrasonic signal filtering unit includes a fixed ultrasonic signal filtering unit and a differential ultrasonic signal denoising unit.

An input terminal of the second voltage following unit is connected to a second analog voltage signal, and an output terminal of the second voltage following unit is connected to an input terminal of the fixed ultrasonic signal filtering unit.

An output terminal of the fixed ultrasonic signal filtering unit is connected to an input terminal of the differential ultrasonic signal denoising unit, the input terminal of the differential ultrasonic signal denoising unit is also connected to an ultrasonic filtering port of the MCU, and an output terminal of the differential ultrasonic signal denoising unit is connected to an input terminal of the ultrasonic program-controlled amplification unit.

The input terminal of the ultrasonic program-controlled amplification unit is also connected to an ultrasonic amplification port of the MCU, and an output terminal of the ultrasonic program-controlled amplification unit is connected to the input terminal of the MCU.

Further, the fixed ultrasonic signal filtering unit is set as a second-order active band-pass filter with a low cut-off frequency of 20 kHz and a high cut-off frequency of 200 kHz based on a frequency band from 20 kHz to 200 kHz of the ultrasonic signal.

In this embodiment, the front-end conditioning unit includes a signal input interface and a third voltage following unit, an input terminal of the signal input interface receives the ultrasonic-vibration fusion signal collected by the sensor, an output terminal of the signal input interface is connected to an input terminal of the third voltage following unit, and an output terminal of the third voltage following unit outputs the two analog voltage signals.

According to the invention, the MCU includes an MCU controller, an ADC, and a DAC. An output terminal of the vibration conditioning unit is connected to a signal input terminal of the ADC, and an analog signal on the output terminal of the vibration conditioning unit is output from a vibration feedback terminal of the ADC after undergoing analog-to-digital conversion; the vibration feedback terminal of the ADC is connected to an input terminal of the MCU controller, and an amplification factor used by the vibration conditioning unit for the vibration signal is controlled through a vibration amplification port of the MCU controller after internal processing by the MCU controller; a vibration filtering control port of the MCU controller is connected to an input terminal of the DAC, and a digital signal on the vibration filtering control port of the MCU controller is output from a vibration filtering port of the DAC after undergoing digital-to-analog conversion; the vibration filtering port of the DAC is connected to an input terminal of the vibration conditioning unit to control the vibration conditioning unit to filter and denoise the vibration signal; and an output terminal of the MCU controller is connected to the differential vibration signal denoising unit through the DAC to control the differential vibration signal denoising unit to carry out adaptive differential denoising and adaptive fast spectral kurtosis denoising.

An output terminal of the ultrasonic conditioning unit is connected to the signal input terminal of the ADC, and an analog signal on the output terminal of the ultrasonic conditioning unit is output from an ultrasonic feedback terminal of the ADC after undergoing the analog-to-digital conversion; the ultrasonic feedback terminal of the ADC is connected to the input terminal of the MCU controller, and an amplification factor used by the ultrasonic conditioning unit for the ultrasonic signal is controlled through an ultrasonic amplification port of the MCU controller after the internal processing by the MCU controller; an ultrasonic filtering control port of the MCU controller is connected to the input terminal of the DAC, and a digital signal on the ultrasonic filtering control port of the MCU controller is output from an ultrasonic filtering port of the DAC after undergoing the digital-to-analog conversion; and the ultrasonic filtering port of the DAC is connected to an input terminal of the ultrasonic conditioning unit to control the ultrasonic conditioning unit to filter and denoise the ultrasonic signal. The output terminal of the MCU controller is connected to the differential ultrasonic signal denoising unit through the DAC to control the differential ultrasonic signal denoising unit to carry out the adaptive differential denoising and the adaptive fast spectral kurtosis denoising.

Further, in this embodiment, for the first voltage following unit, the second voltage following unit, and the third voltage following unit, in an effective solution, a signal output terminal is connected to a forward input terminal of an operational amplifier, and a reverse input terminal of the operational amplifier is connected to an output terminal of the operational amplifier, to form a voltage follower. It should be noted that a type of the operational amplifier includes but is not limited to an operational amplifier with high input impedance (JFET operational amplifier), and a bandwidth of the operational amplifier is greater than 1 MHz.

Further, for the fixed filtering units in the vibration signal filtering unit and the ultrasonic signal filtering unit, in an effective solution, the second-order active low-pass filter is connected to the second-order active band-pass filter, which can minimize a power consumption and a cost while ensuring a good and stable filtering effect. A bandwidth of an operational amplifier of the active filter is greater than 1 MHz.

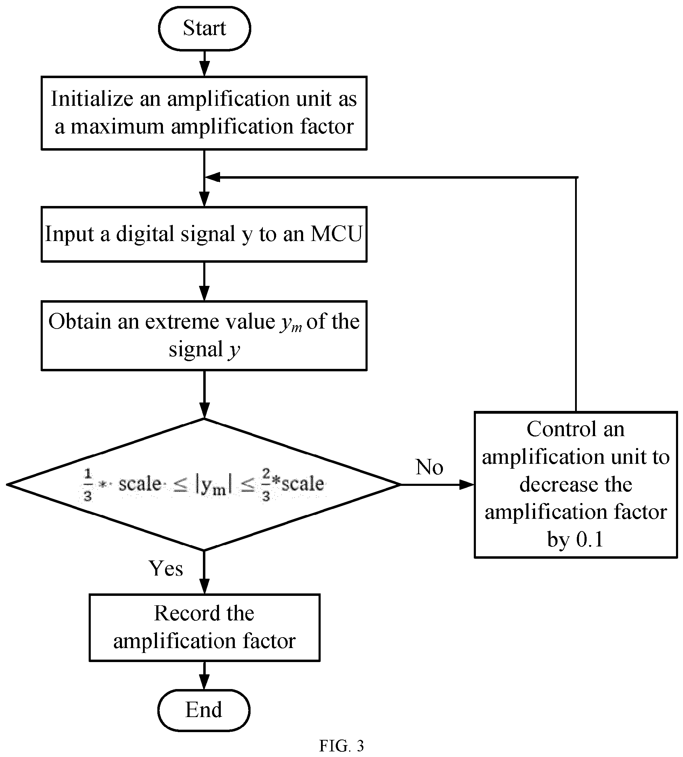

FIG. 3 is a principle diagram of the adaptive conditioning circuit supporting ultrasonic-vibration fusion in this embodiment. First of all, it can be seen from the figure that a resistor R1 and an operational amplifier U1 constitute the front-end conditioning unit, the vibration-ultrasonic fusion signal is input to a forward input terminal of the U1, and a reverse input terminal of the U1 is connected to an output terminal of the U1. The front-end resistor R1 is disposed to avoid potential suspension caused by the vibration-ultrasonic fusion signal output by the sensor and ensure normal signal conditioning.

In the circuit shown in FIG. 3, U2 is the first voltage following unit, and R2, R3, C1, C2 and U4 in the circuit constitute the second-order active low-pass filter of the fixed vibration signal filtering unit. A specific formula for calculating the cut-off frequency of the second-order active low-pass filter is

$$f_1 = \frac{1}{2\pi\sqrt{R_2 \Box R_3 \Box C_1 \Box C_3}}.$$

Sizes of the R2 and the R3 are program-controlled by the MCU to change the cut-off frequency of the second-order active low-pass filter, so as to meet adaptive filtering requirements of different test devices and measurement environments, and separate the vibration signal. For the differential vibration signal denoising unit, in an effective solution, the forward input terminal of the operational amplifier is connected to the output terminal of the fixed filtering unit, and the reverse input terminal is connected to a vibration filtering output port of the DAC. The output terminal of the differential denoising unit outputs a denoised signal, so as to realize differential denoising. The bandwidth of the operational amplifier is greater than 1 MHz. In the circuit shown in FIG. 3, R9, R10, R11, R12, and U6 constitute a differential circuit in the differential vibration signal denoising unit, where R9=R10, R11=R12, and an output terminal of the U6 outputs a denoised vibration signal.

Similar to the conditioning of the vibration signal, in the circuit shown in FIG. 3, U3 is the second voltage following unit, and R4, R5, R6, R7, R8, C3, C4 and U5 in the circuit constitute the second-order active band-pass filter of the fixed ultrasonic signal filtering unit. The second-order active band-pass filter has a center frequency of

$$f_0 = \frac{1}{2\pi}\sqrt{\frac{1}{R_6 C_3 C_4}\left(\frac{1}{R_4} + \frac{1}{R_5}\right)}$$

and a bandwidth of

$$\Delta f = \frac{1}{2\pi\sqrt{C_3 C_4}}\left(\frac{1}{R_4} + \frac{2}{R_6} - \frac{R_7}{R_5 R_7}\right).$$

Sizes of the R5, the R6, the R7, and the R8 are program-controlled by the MCU to change the center frequency and the bandwidth of the second-order active band-pass filter, so as to meet adaptive filtering requirements of different test devices and measurement environments, and separate the ultrasonic signal. In the circuit, R13, R14, R15, R16, U7, and U9 constitute the ultrasonic program-controlled amplification unit, and an output terminal of the U9 is used for ultrasonic output. In other words, it outputs an amplified ultrasonic signal. The R13, the R14, the R15, the R16, and the U7 constitute a differential circuit in the differential ultrasonic signal denoising unit, where R13=R14, R15=R16, and an output terminal of the U7 outputs a denoised ultrasonic signal.

In an effective solution, a program-controlled gain operational amplifier is selected as the vibration program-controlled amplification unit (or the ultrasonic program-controlled amplification unit). An input terminal of the program-controlled gain operational amplifier is connected to an output terminal of the vibration signal filtering unit (or the ultrasonic signal filtering unit), and a vibration amplification output port (or an ultrasonic amplification output port) of the MCU is connected to a program-controlled input terminal of the program-controlled gain operational amplifier to realize feedback adjustment of an amplification gain. A bandwidth of the program-controlled gain operational amplifier shall be greater than 1 MHz, and a gain shall be adjustable within 0~40 dB in an effective operating frequency band.

An output signal of the sensor is used as a signal of a precision instrument, and the amplification unit shall meet a requirement of low noise. The program-controlled gain operational amplifier may be one of electronic devices of models including but not limited to AD603, PGA100, and the like. In FIG. 3, the U8 and the U9 are program-controlled gain operational amplifiers. The MCU achieves an adaptive gain for the vibration and ultrasonic signals through a program-controlled output terminal.

In another effective solution, a low-noise and high-gain operational amplifier is selected as the vibration program-controlled amplification unit (or the ultrasonic program-controlled amplification unit), and a proportional amplification circuit is built based on the operational amplifier. A program-controlled adjustable resistor is selected as a proportional resistor. A ratio of a maximum value to a minimum value of a performance parameter of the program-controlled adjustable resistor is more than 1000 times. The operational amplifier should have a bandwidth greater than 1 MHz, a maximum gain greater than 40 dB, and low noise.

In addition, in this embodiment, performance parameters of the ADC need to meet certain requirements. Specifically, it is required that a minimum sampling rate is required to be 1 MHz, a minimum resolution is 16 bits, and a quantization error is less than 1 LSB. Performance parameters of the DAC need to meet certain requirements. Specifically, it is required that a minimum conversion rate is 1 MHz, the minimum resolution is 16 bits, and the quantization error is less than 1 LSB.

As a core of the adaptive conditioning circuit, the MCU realizes feedback control over the adaptive amplification and denoising, including but not limited to a single-chip microcomputer module, a field programmable gate array (FPGA) module, a digital signal processor (DSP) module, and other hardware, and requires a minimum operation rate of 4 MHz.

In this embodiment, the adjusting an amplification factor of the adaptive amplification based on feedback signals of the ultrasonic-vibration fusion signal includes following steps:

Step 1: Initialize the MCU, and set the amplification factor of the program-controlled amplification unit to a maximum multiple, where the maximum multiple can be used to amplify a small signal to a full scale by default, and the maximum multiple is specifically a multiple used by the program-controlled amplification unit to amplify a unit signal to the full scale.

Step 2: Connect a vibration output signal to an ADC module for analog-to-digital conversion, input an obtained vibration feedback digital signal to the MCU for digital processing.

Step 3: Obtain an extreme value of a signal output by the program-controlled amplification unit.

Step 4: Determine whether an absolute value of the extreme value of the signal is between 1/3 of the full scale and 2/3 of the full scale; and end adaptive adjustment if the absolute value of the extreme value of the signal is between 1/3 of the full scale and 2/3 of the full scale, or perform step 5 if the absolute value of the extreme value of the signal is not between 1/3 of the full scale and 2/3 of the full scale.

Step 5: Adjust the amplification factor of the program-controlled amplification unit by the MCU based on a preset step size, and repeat the steps 2 to 4 based on an adjusted amplification factor.

Further, the adjusting the amplification factor of the program-controlled amplification unit by the MCU based on a preset step size includes:

increasing the amplification factor by the preset step size when the absolute value of the extreme value of the signal is smaller than 1/3 of the full scale; or

decreasing the amplification factor by the preset step size when the absolute value of the extreme value of the signal is greater than 2/3 of the full scale.

In this embodiment, adaptive amplification processes for the vibration signal and the ultrasonic signal are the same. Adaptive amplification with a preset step size of 0.1 for the vibration signal is taken as an example, and adaptive amplification of the ultrasonic signal is the same. The adaptive control process is shown in FIG. 3. When the adaptive control is started, an initial amplification unit of the vibration program-controlled amplification unit is first set as the maximum amplification factor, and then the ADC converts the vibration signal output by the vibration program-controlled amplification unit into a digital signal y and inputs the digital signal y to the MCU controller to obtain an extreme value $y_m$ of the signal y. If the $y_m$ meets a following condition:

$$\frac{1}{3} * \ \text{scale} \ \leq |y_m| \leq \frac{2}{3} * \text{scale}$$, the amplification

factor is recorded as a current amplification factor of the vibration program-controlled amplification unit, and the control process ends. If the $y_m$ does not meet the above condition, the amplification unit is controlled to decrease the amplification factor by 0.1 or increase the amplification factor by 0.1.

It can be seen that if the absolute value of the extreme value of the signal is between 1/3 of the full scale and 2/3 of the full scale, it is proved that a signal amplitude conforms to a visible range, in other words, the amplification factor of the program-controlled amplification unit is appropriate at this time. Further, the steps 2 to 5 are cyclically performed to achieve the adaptive adjustment of the signal amplification factor based on feedback signals output by the vibration conditioning unit and the ultrasonic conditioning unit, such that the adaptive conditioning circuit supporting ultrasonic-vibration fusion can perform the adaptive adjustment based on different characteristics of the vibration signal and the ultrasonic signal.

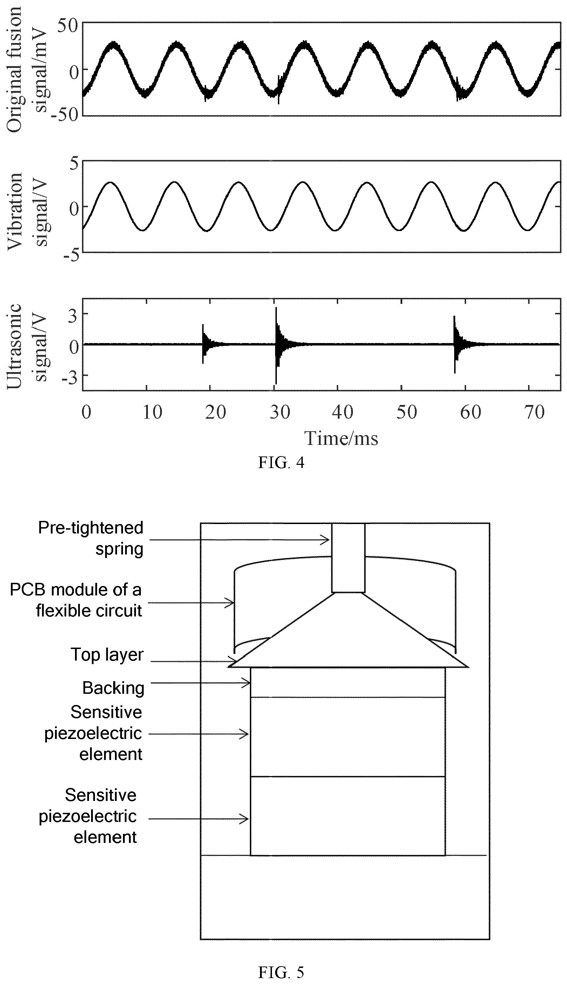

In this embodiment, a signal conditioning effect of the adaptive conditioning circuit supporting ultrasonic-vibration fusion is shown in FIG. 4. After being processed by the adaptive conditioning circuit supporting ultrasonic-vibration fusion, an original fusion signal collected by the sensor is effectively separated and denoised, such that an amplitude of the vibration signal is 2.5 V, and an amplitude of the ultrasonic signal is 3.1 V, thereby achieving the adaptive amplification of the vibration and ultrasonic signals separately.

Embodiment 2

This embodiment provides a flexible module, where the flexible module is provided with the adaptive conditioning circuit supporting ultrasonic-vibration fusion in Embodiment 1.

Further, the flexible module is a flexible printed circuit board covered with an electromagnetic shielding film, and the flexible printed circuit board is installed on a housing of a sensor.

In this embodiment, a material of the flexible printed circuit board may include but is not limited to polyimide, and a conductive material used for the adaptive conditioning circuit supporting ultrasonic-vibration fusion may include but is not limited to a rolled annealed copper material. In consideration of electromagnetic interference generated after the flexible module is installed in the sensor, an upper part of the printed circuit board is covered with an electromagnetic shielding film to shield an external electromagnetic interference signal.

In this embodiment, the installation of the flexible module in the sensor is shown in FIG. 5. The sensor includes a plurality of sensitive piezoelectric elements, a backing, and a top layer. It can be seen from the figure that the flexible module is installed at an edge of a housing on the top layer of the sensor, and is fixed by a pre-tightened spring, which realizes effective implantation without affecting an internal structure of the sensor, and improves portability of the sensor.

The serial numbers in the above embodiments are only for description, and do not represent a sequence of assembling or using the components.

The above described are merely embodiments of the present disclosure and are not intended to limit the present disclosure.

**Claims**

1. An adaptive conditioning circuit supporting ultrasonic-vibration fusion, wherein the adaptive conditioning circuit supporting ultrasonic-vibration fusion comprises a front-end conditioning unit, a vibration conditioning unit, an ultrasonic conditioning unit, and a microcontroller unit, MCU, wherein the vibration conditioning unit and the ultrasonic conditioning unit both comprise a voltage following unit, a filtering unit, and a program-controlled amplification unit, an input terminal of the MCU is connected to an output terminal of the program-controlled amplification unit, and an output terminal of the MCU is separately connected to an input terminal of the filtering unit and an input terminal of the program-controlled amplification unit;

　　　the front-end conditioning unit is configured to obtain an ultrasonic-vibration fusion signal collected by a sensor, and process the ultrasonic-vibration fusion signal to obtain two analog voltage signals;
　　　the vibration conditioning unit is configured to perform adaptive filtering, denoising, and amplification on a vibration signal in the analog voltage signal;
　　　the ultrasonic conditioning unit is configured to perform adaptive filtering, denoising, and amplification on an ultrasonic signal in the analog voltage signal; and
the MCU is configured to control the filtering and the denoising of the vibration conditioning unit and the ultrasonic conditioning unit, and adjust an amplification factor of the adaptive amplification based on feedback signals output by the vibration conditioning unit and the ultrasonic conditioning unit;
wherein the MCU comprises an MCU controller, an analog-digital converter, ADC, and a digital-analog converter, DAC;
an output terminal of the vibration conditioning unit is connected to a signal input terminal of the ADC, and an analog signal on the output terminal of the vibration conditioning unit is output from a vibration feedback terminal of the ADC after undergoing analog-to-digital conversion; the vibration feedback terminal of the ADC is connected to an input terminal of the MCU controller, and an amplification factor used by the vibration conditioning unit for the vibration signal is controlled through a vibration amplification port of the MCU controller after internal processing by the MCU controller; a vibration filtering control port of the MCU controller is connected to an input terminal of the DAC, and a digital signal on the vibration filtering control port of the MCU controller is output from a vibration filtering port of the DAC after undergoing digital-to-analog conversion; and the vibration filtering port of the DAC is connected to an input terminal of the vibration conditioning unit to control the vibration conditioning unit to filter and denoise the vibration signal; and
an output terminal of the ultrasonic conditioning unit is connected to the signal input terminal of the ADC, and an analog signal on the output terminal of the ultrasonic conditioning unit is output from an ultrasonic feedback terminal of the ADC after undergoing the analog-to-digital conversion; the ultrasonic feedback terminal of the ADC is connected to the input terminal of the MCU controller, and an amplification factor used by the ultrasonic conditioning unit for the ultrasonic signal is controlled through an ultrasonic amplification port of the MCU controller after the internal processing by the MCU controller; an ultrasonic filtering control port of the MCU controller is connected to the input terminal of the DAC, and a digital signal on the ultrasonic filtering control port of the MCU controller is output from an ultrasonic filtering port of the DAC after undergoing the digital-to-analog conversion; and the ultrasonic filtering port of the DAC is connected to an input terminal of the ultrasonic conditioning unit to control the ultrasonic conditioning unit to filter and denoise the ultrasonic signal.

2. The adaptive conditioning circuit supporting ultrasonic-vibration fusion according to claim 1, wherein the vibration conditioning unit comprises a first voltage following unit, a vibration signal filtering unit, and a vibration program-controlled amplification unit, and the vibration signal filtering unit comprises a fixed vibration signal filtering unit and a differential vibration signal denoising unit;

an input terminal of the first voltage following unit is connected to a first analog voltage signal, and an output terminal of the first voltage following unit is connected to an input terminal of the fixed vibration signal filtering unit;
an output terminal of the fixed vibration signal filtering unit is connected to an input terminal of the differential vibration signal denoising unit, the input terminal of the differential vibration signal denoising unit is also connected to a vibration filtering port of the MCU, and an output terminal of the differential vibration signal denoising unit is connected to an input terminal of the vibration program-controlled amplification unit; and
the input terminal of the vibration program-controlled amplification unit is also connected to a vibration amplification port of the MCU, and an output terminal of the vibration program-controlled amplification unit is connected to the input terminal of the MCU.

3. The adaptive conditioning circuit supporting ultrasonic-vibration fusion according to claim 1, wherein the ultrasonic conditioning unit comprises a second voltage following unit, an ultrasonic signal filtering unit, and an ultrasonic program-controlled amplification unit, and the ultrasonic signal filtering unit comprises a fixed ultrasonic signal filtering unit and a differential ultrasonic signal denoising unit;

an input terminal of the second voltage following unit is connected to a second analog voltage signal, and an output terminal of the second voltage following unit is connected to an input terminal of the fixed ultrasonic signal filtering unit;
an output terminal of the fixed ultrasonic signal filtering unit is connected to an input terminal of the differential ultrasonic signal denoising unit, the input terminal of the differential ultrasonic signal denoising unit is also connected to an ultrasonic filtering port of the MCU, and an output terminal of the differential ultrasonic signal denoising unit is connected to an input terminal of the ultrasonic program-controlled amplification unit; and
the input terminal of the ultrasonic program-controlled amplification unit is also connected to an ultrasonic amplification port of the MCU, and an output terminal of the ultrasonic program-controlled amplification unit is connected to the input terminal of the MCU.

4. The adaptive conditioning circuit supporting ultrasonic-vibration fusion according to claim 1, wherein the front-end conditioning unit comprises a signal input interface and a third voltage following unit, an input terminal of the signal input interface receives the ultrasonic-vibration fusion signal collected by the sensor, an output terminal of the signal input interface is connected to an input terminal of the third voltage following unit, and an output terminal of the third voltage following unit outputs the two analog voltage signals.

5. The adaptive conditioning circuit supporting ultrasonic-vibration fusion according to claim 1, wherein the adjusting an amplification factor of the adaptive amplification based on feedback signals of the ultrasonic-vibration fusion signal comprises:

step 1: initializing the MCU, and setting the amplification factor of the program-controlled amplification unit to a maximum multiple, wherein the maximum multiple is used to amplify a small signal to a full scale by default;
step 2: connecting a vibration output signal to an ADC module for analog-to-digital conversion, obtaining a vibration feedback digital signal, and inputting the vibration feedback digital signal to the MCU for digital processing;
step 3: obtaining an extreme value of a signal output by the program-controlled amplification unit;
step 4: determining whether an absolute value of the extreme value of the signal is between 1/3 of the full scale and 2/3 of the full scale; and ending adaptive adjustment if the absolute value of the extreme value of the signal is between 1/3 of the full scale and 2/3 of the full scale, or performing step 5 if the absolute value of the extreme value of the signal is not between 1/3 of the full scale and 2/3 of the full scale; and
step 5: adjusting the amplification factor of the program-controlled amplification unit by the MCU based on a preset step size, and repeating the steps 2 to 4 based on an adjusted amplification factor.

6. The adaptive conditioning circuit supporting ultrasonic-vibration fusion according to claim 5, wherein the maximum multiple is a multiple used by the program-controlled amplification unit to amplify a unit signal to the full scale.

7. The adaptive conditioning circuit supporting ultrasonic-vibration fusion according to claim 5, wherein the adjusting the amplification factor of the program-controlled amplification unit by the MCU based on a preset step size comprises:

increasing the amplification factor by the preset step size when the absolute value of the extreme value of the signal is smaller than 1/3 of the full scale; or
decreasing the amplification factor by the preset step size when the absolute value of the extreme value of the signal is greater than 2/3 of the full scale.

8. A flexible module, wherein the flexible module is provided with the adaptive conditioning circuit supporting ultrasonic-vibration fusion according to any one of claims 1 to 7.

9. The flexible module according to claim 8, wherein the flexible module is a flexible printed circuit board covered with an electromagnetic shielding film, and the flexible printed circuit board is installed on a housing of a sensor.

**Patentansprüche**

1. Adaptive Aufbereitungsschaltung zur Unterstützung der Ultraschall-Schwingungs-Fusion, wobei die adaptive Aufbereitungsschaltung zur Unterstützung der Ultraschall-Schwingungs-Fusion eine Front-End-Aufbereitungseinheit, eine Schwingungs-Aufbereitungseinheit, eine Ultraschall-Aufbereitungseinheit und eine Mikrocontroller-Einheit, MCU, umfasst, wobei die Schwingungs-Aufbereitungseinheit und die Ultraschall-Aufbereitungseinheit jeweils eine Spannungsfolgeeinheit, eine Filtereinheit und eine programmgesteuerte Verstärkungseinheit umfassen, ein Eingangsanschluss der MCU mit einem Ausgangsanschluss der programmgesteuerten Verstärkungseinheit verbunden ist, und ein Ausgangsanschluss der MCU jeweils separat mit einem Eingangsanschluss der Filtereinheit und einem Eingangsanschluss der programmgesteuerten Verstärkungseinheit verbunden ist;

die Front-End-Aufbereitungseinheit ist dazu konfiguriert, ein von einem Sensor erfasstes Ultraschall-Schwingungs-Fusionssignal zu erhalten und das Ultraschall-Schwingungs-Fusionssignal zu verarbeiten, um zwei analoge Spannungssignale zu erhalten;
die Schwingungs-Aufbereitungseinheit ist dazu konfiguriert, eine adaptive Filterung, Rauschunterdrückung und Verstärkung an einem Schwingungssignal in dem analogen Spannungssignal durchzuführen;
die Ultraschall-Aufbereitungseinheit ist dazu konfiguriert, eine adaptive Filterung, Rauschunterdrückung und Verstärkung an einem Ultraschallsignal in dem analogen Spannungssignal durchzuführen; und
die MCU ist dazu konfiguriert, die Filterung und die Rauschunterdrückung der Schwingungs-Aufbereitungseinheit und der Ultraschall-Aufbereitungseinheit zu steuern und einen Verstärkungsfaktor der adaptiven Verstärkung auf Grundlage von Rückkopplungssignalen einzustellen, die von der Schwingungs-Aufbereitungseinheit und der Ultraschall-Aufbereitungseinheit ausgegeben werden;
wobei die MCU einen MCU-Controller, einen Analog-Digital-Wandler, ADC, und einen Digital-Analog-Wandler, DAC, umfasst;
ein Ausgangsanschluss der Schwingungs-Aufbereitungseinheit ist mit einem Signaleingangsanschluss des ADC verbunden, und ein analoges Signal an dem Ausgangsanschluss der Schwingungs-Aufbereitungseinheit wird nach Durchführung einer Analog-Digital-Umwandlung von einem Schwingungs-Rückkopplungsanschluss des ADC ausgegeben; der Schwingungs-Rückkopplungsanschluss des ADC ist mit einem Eingangsanschluss des MCU-Controllers verbunden, und ein von der Schwingungs-Aufbereitungseinheit für das Schwingungssignal verwendeter Verstärkungsfaktor wird nach interner Verarbeitung durch den MCU-Controller über einen Schwingungsverstärkungsanschluss des MCU-Controllers gesteuert; ein Schwingungsfilter-Steueranschluss des MCU-Controllers ist mit einem Eingangsanschluss des DAC verbunden, und ein digitales Signal an dem Schwingungsfilter-Steueranschluss des MCU-Controllers wird nach Durchführung einer Digital-Analog-Umwandlung von einem Schwingungsfilteranschluss des DAC ausgegeben; und der Schwingungsfilteranschluss des DAC ist mit einem Eingangsanschluss der Schwingungs-Aufbereitungseinheit verbunden, um die Schwingungs-Aufbereitungseinheit zur Filterung und Rauschunterdrückung des Schwingungssignals zu steuern; und ein Ausgangsanschluss der Ultraschall-Aufbereitungseinheit ist mit dem Signaleingangsanschluss des ADC verbunden, und ein analoges Signal an dem Ausgangsanschluss der Ultraschall-Aufbereitungseinheit wird nach Durchführung der Analog-Digital-Umwandlung von einem Ultraschall-Rückkopplungsanschluss des ADC ausgegeben; der Ultraschall-Rückkopplungsanschluss des ADC ist mit dem Eingangsanschluss des MCU-Controllers verbunden, und ein von der Ultraschall-Aufbereitungseinheit für das Ultraschallsignal verwendeter Verstärkungsfaktor wird nach der internen Verarbeitung durch den MCU-Controller über einen Ultraschallverstärkungsanschluss des MCU-Controllers gesteuert; ein Ultraschallfilter-Steueranschluss des MCU-Controllers ist mit dem Eingangsanschluss des DAC verbunden, und ein digitales Signal an dem Ultraschallfilter-Steueranschluss des MCU-Controllers wird nach Durchführung der Digital-Analog-Umwandlung von einem Ultraschallfilteranschluss des DAC ausgegeben; und der Ultraschallfilteranschluss des DAC ist mit einem Eingangsanschluss der Ultraschall-Aufbereitungseinheit verbunden, um die Ultraschall-Aufbereitungseinheit zur Filterung und Rauschunterdrückung des Ultraschallsignals zu steuern.

2. Adaptive Aufbereitungsschaltung zur Unterstützung der Ultraschall-Schwingungs-Fusion nach Anspruch 1, wobei die Schwingungs-Aufbereitungseinheit eine erste Spannungsfolgeeinheit, eine Schwingungssignal-Filtereinheit und eine Schwingungs-programmgesteuerte Verstärkungseinheit umfasst, und die Schwingungssignal-Filtereinheit eine feste Schwingungssignal-Filtereinheit und eine differentielle Schwingungssignal-Rauschunterdrückungseinheit umfasst;

ein Eingangsanschluss der ersten Spannungsfolgeeinheit ist mit einem ersten analogen Spannungssignal verbunden, und ein Ausgangsanschluss der ersten Spannungsfolgeeinheit ist mit einem Eingangsanschluss der festen Schwingungssignal-Filtereinheit verbunden;
ein Ausgangsanschluss der festen Schwingungssignal-Filtereinheit ist mit einem Eingangsanschluss der differentiellen Schwingungssignal-Rauschunterdrückungseinheit verbunden, der Eingangsanschluss der differentiellen Schwingungssignal-Rauschunterdrückungseinheit ist außerdem mit einem Schwingungsfilteranschluss der MCU verbunden, und ein Ausgangsanschluss der differentiellen Schwingungssignal-Rauschunterdrückungseinheit ist mit einem Eingangsanschluss der Schwingungs-programmgesteuerten Verstärkungseinheit verbunden; und der Eingangsanschluss der Schwingungs-programmgesteuerten Verstärkungseinheit ist außerdem mit einem Schwingungsverstärkungsanschluss der MCU verbunden, und ein Ausgangsanschluss der Schwingungs-programmgesteuerten Verstärkungseinheit ist mit dem Eingangsanschluss der MCU verbunden.

3. Adaptive Aufbereitungsschaltung zur Unterstützung der Ultraschall-Schwingungs-Fusion nach Anspruch 1, wobei die Ultraschall-Aufbereitungseinheit eine zweite Spannungsfolgeeinheit, eine Ultraschallsignal-Filtereinheit und eine Ultraschall-programmgesteuerte Verstärkungseinheit umfasst, und die Ultraschallsignal-Filtereinheit eine feste Ultraschallsignal-Filtereinheit und eine differentielle Ultraschallsignal-Rauschunterdrückungseinheit umfasst;

ein Eingangsanschluss der zweiten Spannungsfolgeeinheit ist mit einem zweiten analogen Spannungssignal verbunden, und ein Ausgangsanschluss der zweiten Spannungsfolgeeinheit ist mit einem Eingangsanschluss der festen Ultraschallsignal-Filtereinheit verbunden;
ein Ausgangsanschluss der festen Ultraschallsignal-Filtereinheit ist mit einem Eingangsanschluss der differentiellen Ultraschallsignal-Rauschunterdrückungseinheit verbunden, der Eingangsanschluss der differentiellen Ultraschallsignal-Rauschunterdrückungseinheit ist außerdem mit einem Ultraschallfilteranschluss der MCU verbunden, und ein Ausgangsanschluss der differentiellen Ultraschallsignal-Rauschunterdrückungseinheit ist mit einem Eingangsanschluss der Ultraschall-programmgesteuerten Verstärkungseinheit verbunden; und der Eingangsanschluss der Ultraschall-programmgesteuerten Verstärkungseinheit ist außerdem mit einem Ultraschallverstärkungsanschluss der MCU verbunden, und ein Ausgangsanschluss der Ultraschall-programmgesteuerten Verstärkungseinheit ist mit dem Eingangsanschluss der MCU verbunden.

4. Adaptive Aufbereitungsschaltung zur Unterstützung der Ultraschall-Schwingungs-Fusion nach Anspruch 1, wobei die Front-End-Aufbereitungseinheit eine Signaleingangsschnittstelle und eine dritte Spannungsfolgeeinheit umfasst, ein Eingangsanschluss der Signaleingangsschnittstelle das von dem Sensor erfasste Ultraschall-Schwingungs-Fusionssignal empfängt, ein Ausgangsanschluss der Signaleingangsschnittstelle mit einem Eingangsanschluss der dritten Spannungsfolgeeinheit verbunden ist, und ein Ausgangsanschluss der dritten Spannungsfolgeeinheit die zwei analogen Spannungssignale ausgibt.

5. Adaptive Aufbereitungsschaltung zur Unterstützung der Ultraschall-Schwingungs-Fusion nach Anspruch 1, wobei das Einstellen eines Verstärkungsfaktors der adaptiven Verstärkung auf Grundlage von Rückkopplungssignalen des Ultraschall-Schwingungs-Fusionssignals Folgendes umfasst:

Schritt 1: Initialisieren der MCU und Einstellen des Verstärkungsfaktors der programmgesteuerten Verstärkungseinheit auf ein maximales Vielfaches, wobei das maximale Vielfache verwendet wird, um standardmäßig ein kleines Signal auf Vollaussteuerung zu verstärken;
Schritt 2: Verbinden eines Schwingungsausgangssignals mit einem ADC-Modul zur Analog-Digital-Umwandlung, Erhalten eines Schwingungs-Rückkopplungs-Digitalsignals und Eingeben des Schwingungs-Rückkopplungs-Digitalsignals in die MCU zur digitalen Verarbeitung;
Schritt 3: Erhalten eines Extremwerts eines von der programmgesteuerten Verstärkungseinheit ausgegebenen Signals;
Schritt 4: Bestimmen, ob ein Absolutwert des Extremwerts des Signals zwischen 1/3 der Vollaussteuerung und 2/3 der Vollaussteuerung liegt; und Beenden der adaptiven Einstellung, wenn der Absolutwert des Extremwerts des Signals zwischen 1/3 der Vollaussteuerung und 2/3 der Vollaussteuerung liegt, oder Durchführen von Schritt 5, wenn der Absolutwert des Extremwerts des Signals nicht zwischen 1/3 der Vollaussteuerung und 2/3 der Vollaussteuerung liegt; und
Schritt 5: Einstellen des Verstärkungsfaktors der programmgesteuerten Verstärkungseinheit durch die MCU auf Grundlage einer voreingestellten Schrittweite und Wiederholen der Schritte 2 bis 4 auf Grundlage eines eingestellten Verstärkungsfaktors.

6. Adaptive Aufbereitungsschaltung zur Unterstützung der Ultraschall-Schwingungs-Fusion nach Anspruch 5, wobei das maximale Vielfache ein Vielfaches ist, das von der programmgesteuerten Verstärkungseinheit verwendet wird, um ein Einheitssignal auf die Vollaussteuerung zu verstärken.

7. Adaptive Aufbereitungsschaltung zur Unterstützung der Ultraschall-Schwingungs-Fusion nach Anspruch 5, wobei das Einstellen des Verstärkungsfaktors der programmgesteuerten Verstärkungseinheit durch die MCU auf Grundlage einer voreingestellten Schrittweite Folgendes umfasst:
Erhöhen des Verstärkungsfaktors um die voreingestellte Schrittweite, wenn der Absolutwert des Extremwerts des Signals kleiner als 1/3 der Vollaussteuerung ist; oder Verringern des Verstärkungsfaktors um die voreingestellte Schrittweite, wenn der Absolutwert des Extremwerts des Signals größer als 2/3 der Vollaussteuerung ist.

8. Flexibles Modul, wobei das flexible Modul mit der adaptiven Aufbereitungsschaltung zur Unterstützung der Ultraschall-Schwingungs-Fusion nach einem der Ansprüche 1 bis 7 versehen ist.

9. Flexibles Modul nach Anspruch 8, wobei das flexible Modul eine mit einer elektromagnetischen Abschirmfolie bedeckte flexible Leiterplatte ist, und die flexible Leiterplatte auf einem Gehäuse eines Sensors installiert ist.

**Revendications**

1. Circuit de conditionnement adaptatif prenant en charge la fusion ultrasons-vibrations, dans lequel le circuit de conditionnement adaptatif prenant en charge la fusion ultrasons-vibrations comprend une unité de conditionnement frontal, une unité de conditionnement des vibrations, une unité de conditionnement des ultrasons et une unité de microcontrôleur, MCU, dans lequel l'unité de conditionnement des vibrations et l'unité de conditionnement des ultrasons comprennent toutes deux une unité suiveuse de tension, une unité de filtrage et une unité d'amplification commandée par programme, une borne d'entrée de la MCU est reliée à une borne de sortie de l'unité d'amplification commandée par programme, et une borne de sortie de la MCU est reliée séparément à une borne d'entrée de l'unité de filtrage et à une borne d'entrée de l'unité d'amplification commandée par programme ;

l'unité de conditionnement frontal est configurée pour obtenir un signal de fusion ultrasons-vibrations collecté par un capteur, et traiter le signal de fusion ultrasons-vibrations afin d'obtenir deux signaux de tension analogiques ;
l'unité de conditionnement des vibrations est configurée pour effectuer un filtrage adaptatif, une réduction de bruit et une amplification sur un signal de vibration dans le signal de tension analogique ;
l'unité de conditionnement des ultrasons est configurée pour effectuer un filtrage adaptatif, une réduction de bruit et une amplification sur un signal ultrasonore dans le signal de tension analogique ; et
la MCU est configurée pour commander le filtrage et la réduction de bruit de l'unité de conditionnement des vibrations et de l'unité de conditionnement des ultrasons, et ajuster un facteur d'amplification de l'amplification adaptative sur la base de signaux de retour émis par l'unité de conditionnement des vibrations et l'unité de conditionnement des ultrasons ;
dans lequel la MCU comprend un contrôleur MCU, un convertisseur analogique-numérique, ADC, et un convertisseur numérique-analogique, DAC ;
une borne de sortie de l'unité de conditionnement des vibrations est reliée à une borne d'entrée de signal de l'ADC, et un signal analogique sur la borne de sortie de l'unité de conditionnement des vibrations est émis depuis une borne de retour de vibration de l'ADC après avoir subi une conversion analogique-numérique ; la borne de retour de vibration de l'ADC est reliée à une borne d'entrée du contrôleur MCU, et un facteur d'amplification utilisé par l'unité de conditionnement des vibrations pour le signal de vibration est commandé par l'intermédiaire d'un port d'amplification de vibration du contrôleur MCU après un traitement interne par le contrôleur MCU ; un port de commande de filtrage des vibrations du contrôleur MCU est relié à une borne d'entrée du DAC, et un signal numérique sur le port de commande de filtrage des vibrations du contrôleur MCU est émis depuis un port de filtrage des vibrations du DAC après avoir subi une conversion numérique-analogique ; et le port de filtrage des vibrations du DAC est relié à une borne d'entrée de l'unité de conditionnement des vibrations pour commander l'unité de conditionnement des vibrations afin de filtrer et réduire le bruit du signal de vibration ; et

une borne de sortie de l'unité de conditionnement des ultrasons est reliée à la borne d'entrée de signal de l'ADC, et un signal analogique sur la borne de sortie de l'unité de conditionnement des ultrasons est émis depuis une borne de retour ultrasonore de l'ADC après avoir subi la conversion analogique-numérique ; la borne de retour ultrasonore de l'ADC est reliée à la borne d'entrée du contrôleur MCU, et un facteur d'amplification utilisé par l'unité de conditionnement des ultrasons pour le signal ultrasonore est commandé par l'intermédiaire d'un port d'amplification ultrasonore du contrôleur MCU après le traitement interne par le contrôleur MCU ; un port de commande de filtrage ultrasonore du contrôleur MCU est relié à la borne d'entrée du DAC, et un signal numérique sur le port de commande de filtrage ultrasonore du contrôleur MCU est émis depuis un port de filtrage ultrasonore du DAC après avoir subi la conversion numérique-analogique ; et le port de filtrage ultrasonore du DAC est relié à une borne d'entrée de l'unité de conditionnement des ultrasons pour commander l'unité de conditionnement des ultrasons afin de filtrer et réduire le bruit du signal ultrasonore.

2. Circuit de conditionnement adaptatif prenant en charge la fusion ultrasons-vibrations selon la revendication 1, dans lequel l'unité de conditionnement des vibrations comprend une première unité suiveuse de tension, une unité de filtrage de signal de vibration et une unité d'amplification des vibrations commandée par programme, et l'unité de filtrage de signal de vibration comprend une unité fixe de filtrage de signal de vibration et une unité différentielle de réduction de bruit du signal de vibration ;

une borne d'entrée de la première unité suiveuse de tension est reliée à un premier signal de tension analogique, et une borne de sortie de la première unité suiveuse de tension est reliée à une borne d'entrée de l'unité fixe de filtrage de signal de vibration ;
une borne de sortie de l'unité fixe de filtrage de signal de vibration est reliée à une borne d'entrée de l'unité différentielle de réduction de bruit du signal de vibration, la borne d'entrée de l'unité différentielle de réduction de bruit du signal de vibration est également reliée à un port de filtrage des vibrations de la MCU, et une borne de sortie de l'unité différentielle de réduction de bruit du signal de vibration est reliée à une borne d'entrée de l'unité d'amplification des vibrations commandée par programme ; et
la borne d'entrée de l'unité d'amplification des vibrations commandée par programme est également reliée à un port d'amplification des vibrations de la MCU, et une borne de sortie de l'unité d'amplification des vibrations commandée par programme est reliée à la borne d'entrée de la MCU.

3. Circuit de conditionnement adaptatif prenant en charge la fusion ultrasons-vibrations selon la revendication 1, dans lequel l'unité de conditionnement des ultrasons comprend une deuxième unité suiveuse de tension, une unité de filtrage de signal ultrasonore et une unité d'amplification ultrasonore commandée par programme, et l'unité de filtrage de signal ultrasonore comprend une unité fixe de filtrage de signal ultrasonore et une unité différentielle de réduction de bruit du signal ultrasonore ;

une borne d'entrée de la deuxième unité suiveuse de tension est reliée à un deuxième signal de tension analogique, et une borne de sortie de la deuxième unité suiveuse de tension est reliée à une borne d'entrée de l'unité fixe de filtrage de signal ultrasonore ;
une borne de sortie de l'unité fixe de filtrage de signal ultrasonore est reliée à une borne d'entrée de l'unité différentielle de réduction de bruit du signal ultrasonore, la borne d'entrée de l'unité différentielle de réduction de bruit du signal ultrasonore est également reliée à un port de filtrage ultrasonore de la MCU, et une borne de sortie de l'unité différentielle de réduction de bruit du signal ultrasonore est reliée à une borne d'entrée de l'unité d'amplification ultrasonore commandée par programme ; et

la borne d'entrée de l'unité d'amplification ultrasonore commandée par programme est également reliée à un port d'amplification ultrasonore de la MCU, et une borne de sortie de l'unité d'amplification ultrasonore commandée par programme est reliée à la borne d'entrée de la MCU.

4. Circuit de conditionnement adaptatif prenant en charge la fusion ultrasons-vibrations selon la revendication 1, dans lequel l'unité de conditionnement frontal comprend une interface d'entrée de signal et une troisième unité suiveuse de tension, une borne d'entrée de l'interface d'entrée de signal reçoit le signal de fusion ultrasons-vibrations collecté par le capteur, une borne de sortie de l'interface d'entrée de signal est reliée à une borne d'entrée de la troisième unité suiveuse de tension, et une borne de sortie de la troisième unité suiveuse de tension émet les deux signaux de tension analogiques.

5. Circuit de conditionnement adaptatif prenant en charge la fusion ultrasons-vibrations selon la revendication 1, dans lequel l'ajustement d'un facteur d'amplification de l'amplification adaptative sur la base de signaux de retour du signal de fusion ultrasons-vibrations comprend :

   étape 1 : initialiser la MCU, et régler le facteur d'amplification de l'unité d'amplification commandée par programme sur un multiple maximal, dans lequel le multiple maximal est utilisé pour amplifier par défaut un petit signal jusqu'à la pleine échelle ;
   étape 2 : relier un signal de sortie de vibration à un module ADC pour une conversion analogique-numérique, obtenir un signal numérique de retour de vibration, et entrer le signal numérique de retour de vibration dans la MCU pour un traitement numérique ;
   étape 3 : obtenir une valeur extrême d'un signal émis par l'unité d'amplification commandée par programme ;
   étape 4 : déterminer si une valeur absolue de la valeur extrême du signal se situe entre 1/3 de la pleine échelle et 2/3 de la pleine échelle ; et terminer l'ajustement adaptatif si la valeur absolue de la valeur extrême du signal se situe entre 1/3 de la pleine échelle et 2/3 de la pleine échelle, ou effectuer l'étape 5 si la valeur absolue de la valeur extrême du signal ne se situe pas entre 1/3 de la pleine échelle et 2/3 de la pleine échelle ; et
   étape 5 : ajuster le facteur d'amplification de l'unité d'amplification commandée par programme par la MCU sur la base d'un pas prédéfini, et répéter les étapes 2 à 4 sur la base d'un facteur d'amplification ajusté.

6. Circuit de conditionnement adaptatif prenant en charge la fusion ultrasons-vibrations selon la revendication 5, dans lequel le multiple maximal est un multiple utilisé par l'unité d'amplification commandée par programme pour amplifier un signal unitaire jusqu'à la pleine échelle.

7. Circuit de conditionnement adaptatif prenant en charge la fusion ultrasons-vibrations selon la revendication 5, dans lequel l'ajustement du facteur d'amplification de l'unité d'amplification commandée par programme par la MCU sur la base d'un pas prédéfini comprend :

   augmenter le facteur d'amplification du pas prédéfini lorsque la valeur absolue de la valeur extrême du signal est inférieure à 1/3 de la pleine échelle ; ou
   diminuer le facteur d'amplification du pas prédéfini lorsque la valeur absolue de la valeur extrême du signal est supérieure à 2/3 de la pleine échelle.

8. Module flexible, dans lequel le module flexible est pourvu du circuit de conditionnement adaptatif prenant en charge la fusion ultrasons-vibrations selon l'une quelconque des revendications 1 à 7.

9. Module flexible selon la revendication 8, dans lequel le module flexible est une carte de circuit imprimé flexible recouverte d'un film de blindage électromagnétique, et la carte de circuit imprimé flexible est installée sur un boîtier d'un capteur.

FIG. 1

FIG. 2

```
                    ┌──────────┐
                    │  Start   │
                    └────┬─────┘
                         ▼
        ┌────────────────────────────────────┐
        │ Initialize an amplification unit as │
        │  a maximum amplification factor     │
        └────────────────┬───────────────────┘
                         ▼
        ┌────────────────────────────────────┐
        │ Input a digital signal y to an MCU  │
        └────────────────┬───────────────────┘
                         ▼
        ┌────────────────────────────────────┐
        │ Obtain an extreme value yₘ of the   │
        │             signal y                │
        └────────────────┬───────────────────┘
```

$$\frac{1}{3} * scale \leq |y_m| \leq \frac{2}{3}*scale$$

No

Control an amplification unit to decrease the amplification factor by 0.1

Yes

Record the amplification factor

End

FIG. 3

FIG. 4

FIG. 5

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 110687388 A

- CN 109444691 A